# EUROPEAN PATENT APPLICATION

(11) **EP 2 424 054 A1**
(43) Date of publication of application: **29.02.2012**
(21) Application number: 09843632.2
(22) Date of filing: 20.04.2009
(51) Int. Cl.: H02B 1/56

(54) **UNIT FOR HOUSING ELECTRONIC APPARATUS**

(71) Applicant: Mitsubishi Electric Corporation, Tokyo 100-8310 (JP)
(72) Inventor: YATOU, Tadashi, Nakatsugawa-shi Gifu 508-0041 (JP)
(74) Representative: Pfenning, Meinig & Partner GbR
(86) International application number: PCT/JP2009/057874
(87) International publication number: WO 2010/122632

(57) **Abstract**

The blower 20 is arranged in the lower portion of the power conditioner 3, the heat sink 19 is arranged such that there are clearances between the side surfaces of the heat sink 19 and the side plates 11a and 11b and moreover the heat sink 19 is arranged such that there is a clearance between the upper end portion of the heat sink 19 and the top plate 13, and the exhaust openings 17a and 17b formed in the side plates 11a and 11b are arranged to communicate with the clearances between the side surfaces of the heat sink 19 and the side plates 11a and 11b.

## Description

### Field

The present invention relates to an electronic device accommodating unit, particularly to a waterproof structure of a power conditioner for outdoor installation used in a photovoltaic system.

### Background

A power conditioner is used for enabling to convert a direct current power generated by solar cells into an alternating current power and to supply the alternating current power to a load or supply excess power to an electric power company. When this power conditioner is installed outside, it is generally performed to take a waterproof measure by using packing or caulking for ensuring an internal waterproof property even if the power conditioner is exposed to rainwater at the time of occurrence of a typhoon or the like.

For example, Patent Literature 1 discloses a method of improving measures against rainwater for electric components in an electric component box and heat dissipation of the electric components by forming a plurality of heat dissipation openings in vertical walls of the vertically-elongated rectangular electric component box that accommodates a printed-circuit board on which the electric components for an air conditioner are mounted, arranging waterproof walls in a state of covering the heat dissipation openings with air-flowing intervals of heat dissipation air of the electric components from the inner surfaces of the vertical walls, and supporting the printed-circuit board in a vertical direction on the inner side of the waterproof walls.

### Citation List

### Patent Literature

Patent Literature 1: Japanese Patent Application Laid-open No. 2005-249269

### Summary

### Technical Problem

However, in the method of taking the waterproof measure by using packing or caulking, when the power conditioner is installed outside, the packing and the caulking are exposed to strong sunshine or wind and rain. Therefore, there is a problem that the packing and the caulking degrade early, and if the power conditioner is used for a long period of time, a sufficient waterproof property cannot be obtained, so that the service life of the power conditioner becomes short.

Moreover, in the method disclosed in Patent Literature 1, there is a problem that because the heat dissipation openings are covered by the waterproof walls, a heat dissipation path from the electric components is blocked by the waterproof walls and thus a heat dissipation property is impaired.

The present invention is achieved in view of the above, and has an object to obtain an electronic device accommodating unit capable of ensuring a waterproof property and improving a weather resistance while suppressing deterioration of a heat dissipation property. Solution to Problem

In order to solve the aforementioned problems, an electronic device accommodating unit according to one aspect of the present invention is configured to include: a casing in which a bottom plate, a back plate, a top plate, a front door, and a pair of side plates are provided; a blower that blows air into the casing through the bottom plate; a heat sink in which fins are arranged along a blowing direction of the blower in such a manner as to face the back plate, a side surface is arranged to be spaced apart from the side plate, and an upper end portion is arranged to be spaced apart from the top plate; and an exhaust opening that is provided in the side plate and communicates with a clearance between the side surface of the heat sink and the side plate.

### Advantageous Effects of Invention

According to this invention, the effects are obtained that a waterproof property can be ensured and a weather resistance can be improved while suppressing deterioration of a heat dissipation property.

### Brief Description of Drawings

[FIG. 1] FIG. 1 is a perspective view illustrating a schematic configuration of a photovoltaic system to which an embodiment of an electronic device accommodating unit according to the present invention is applied.
[FIG. 2] FIG. 2 is a perspective view illustrating a schematic configuration of an inside of a front-stage portion FB of a power conditioner 3 partitioned by a partition plate 18.
[FIG. 3] FIG. 3 is a perspective view illustrating a schematic configuration of an inside of a back-stage portion BB of the power conditioner 3 partitioned by the partition plate 18.

### Description of Embodiments

An exemplary embodiment of an electronic device accommodating unit according to the present invention will be explained below in detail based on the drawings. This invention is not limited to this embodiment.

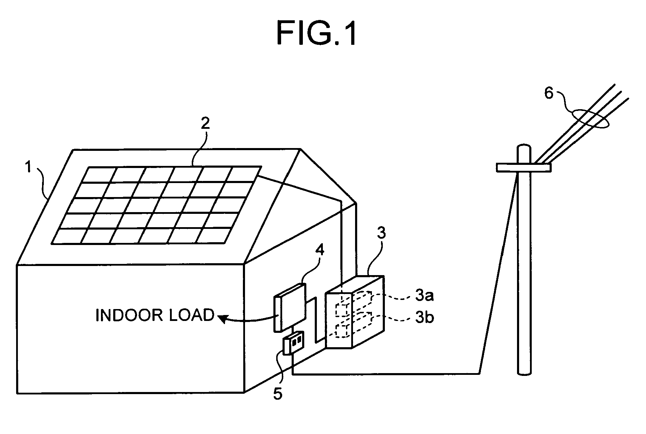

FIG. 1 is a perspective view illustrating a schematic configuration of a photovoltaic system to which the embodiment of the electronic device accommodating unit according to the present invention is applied. In the following embodiment, a power conditioner is explained as the electronic device accommodating unit as an example, however, the electronic device accommodating unit is not limited to the power conditioner and, for example, can be applied to an air conditioning apparatus such as an air conditioner, or the like.

In FIG. 1, a solar panel 2 that converts light into a direct current power is installed on a roof 1 and a power conditioner 3 is installed outside. The solar panel 2 is connected to the DC input terminal of the power conditioner 3. Moreover, the AC output terminal of the power conditioner 3 is connected to an indoor load via a distribution board 4 and is connected to a distribution line 6 via the distribution board 4 and an electricity meter 5.

In the power conditioner 3, a DCDC converter 3a that performs DC conversion of a direct current power generated in the solar panel 2 and an inverter 3b that converts the direct current power output from the DCDC converter 3a into an alternating current power are incorporated.

Then, when the direct current power generated in the solar panel 2 is sent to the power conditioner 3, DC conversion of the direct current power is performed in the DCDC converter 3a, and thereafter, the direct current power is converted into the alternating current power in the inverter 3b to be sent to the distribution board 4. Then, when the alternating current power is sent to the distribution board 4, the alternating current power is supplied to the indoor load and excess power is sent to the distribution line 6 to be taken by an electric power company.

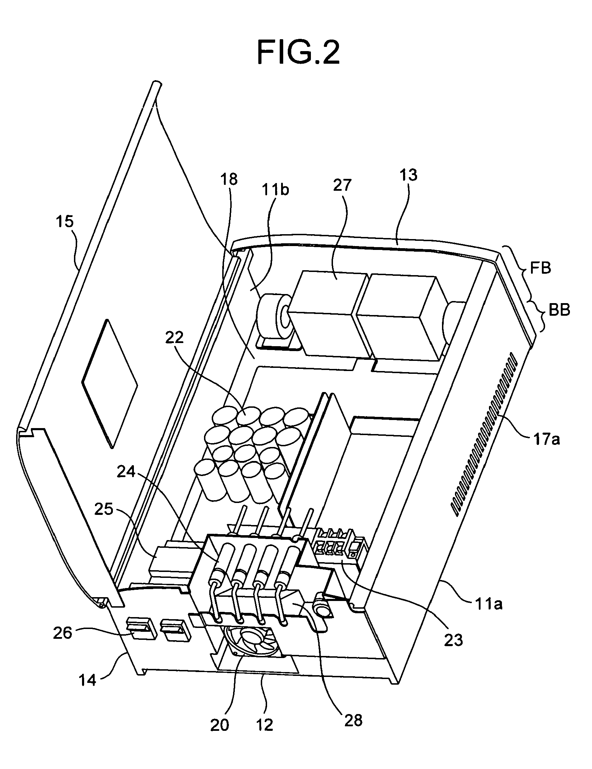

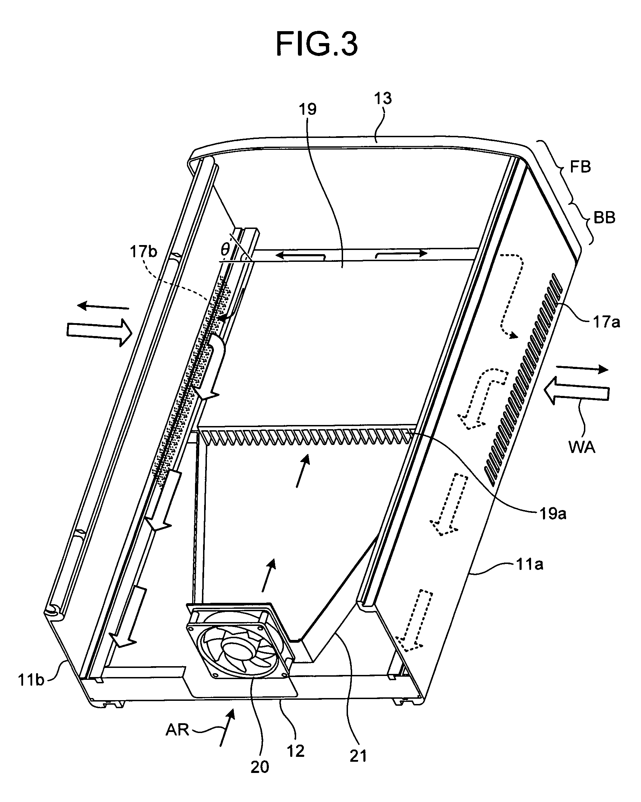

FIG. 2 is a perspective view illustrating a schematic configuration of an inside of a front-stage portion FB of the power conditioner 3 partitioned by a partition plate 18, and FIG. 3 is a perspective view illustrating a schematic configuration of an inside of a back-stage portion BB of the power conditioner 3 partitioned by the partition plate 18. In FIG. 2 and FIG. 3, in the power conditioner 3 in FIG. 1, a bottom plate 14, a back plate 12, a top plate 13, a front door 15, and a pair of side plates 11a and 11b are provided as a casing. The bottom plate 14, the back plate 12, the top plate 13, the front door 15, and a pair of the side plates 11a and 11b can be formed of, for example, metal such as iron, stainless steel, or aluminum. The casing of the power conditioner 3 is partitioned by the partition plate 18 in the depth direction to be divided into the front-stage portion FB and the back-stage portion BB.

In the lower portion of the power conditioner 3, a blower 20 that blows air into the casing through the bottom plate 14 is arranged. The blowing direction of the blower 20 can be set upward by arranging the blower 20 in such a manner as to face the bottom plate 14.

Moreover, as shown in FIG. 3, in the back-stage portion BB of the power conditioner 3, in the upper portion of the power conditioner 3, a heat sink 19 in which heat dissipation fins 19a are formed is arranged. In the heat sink 19, the heat dissipation fins 19a are arranged along the blowing direction of the blower 20 in such a manner as to face the back plate 12. Moreover, the heat sink 19 is arranged such that there are clearances between.the side surfaces of the heat sink 19 and the side plates 11a and 11b and there is a clearance between the upper end portion of the heat sink 19 and the top plate 13.

Furthermore, in the back-stage portion BB of the power conditioner 3, exhaust openings 17a and 17b are formed in the side plates 11a and 11b, respectively. The exhaust openings 17a and 17b can be formed into, for example, a slit shape. The exhaust openings 17a and 17b can be arranged to communicate with the clearances between the side surfaces of the heat sink 19 and the side plates 11a and 11b. Moreover, the exhaust openings 17a and 17b can be formed to communicate with the inside of the back-stage portion BB of the power conditioner 3 and not to communicate with the inside of the front-stage portion FB of the power conditioner 3. Furthermore, the exhaust openings 17a and 17b are preferably arranged at the position lower than the lines that intersect with the side plates 11a and 11b when being drawn in the direction of the side plates 11a and 11b from the upper end portion of the side surfaces of the heat sink 19 at an angle θ of 45°.

Moreover, a separator 21 is arranged between the blower 20 and the side plates 11a and 11b. This separator 21 can separate an air passage from the blower 20 to the heat sink 19 from air passages along the side plates 11a and 11b that communicate with the exhaust openings 17a and 17b.

On the other hand, as shown in FIG. 2, in the front-stage portion FB of the power conditioner 3, capacitors 22, a surge absorber 25, a reactor 27, and the like are arranged on the partition plate 18. The partition plate 18 can be arranged on the heat dissipation surface of the heat sink 19 to cover the clearances between the side surfaces of the heat sink 19 and the side plates 11a and 11b and the clearance between the upper end portion of the heat sink 19 and the top plate 13. The capacitors 22, the surge absorber 25, the reactor 27, and the like can be used as electronic components forming the DCDC converter 3a and the inverter 3b in FIG. 1.

Moreover, on the partition plate 18, an AC terminal block 23, DC input terminals 24, and the like are arranged, and a switch 26 is attached to the bottom plate 14. Furthermore, the portion of the blower 20 projecting to the front-stage portion FB side is covered by a blower cover 28. The blower cover 28 can send air AR taken in by the blower 20 to the back-stage portion BB side.

Then, the air AR taken in by the blower 20 is sent to the back-stage portion BB side by the blower cover 28, and is sent to the lower end portion of the heat sink 19 through the air passage defined by the back plate 12, the partition plate 18, and the separator 21.

Then, the air AR sent to the lower end portion of the heat sink 19 is discharged from the upper end portion of the heat sink 19 while cooling the heat sink 19 by passing between the heat dissipation fins 19a. Then, the path of the air AR discharged from the upper end portion of the heat sink 19 is bent by the top plate 13 to be directed to the directions of the side plates 11a and 11b. Then, the air AR directed to the directions of the side plates 11a and 11b travels through the clearances between the side surfaces of the heat sink 19 and the side plates 11a and 11b and is discharged to the outside through the exhaust openings 17a and 17b.

On the other hand, when the power conditioner 3 is installed outside, the power conditioner 3 is exposed to strong sunshine or wind and rain. Then, when the power conditioner 3 is exposed to wind and rain, if rainwater WA enters the inside via the exhaust openings 17a and 17b, the rainwater WA falls downward of the power conditioner 3 by gravity. When the rainwater WA falls downward of the power conditioner 3 by gravity, ingress of the rainwater WA to the blast surface of the blower 20 is prevented by the side surfaces of the heat sink 19 and the separator 21 and the ingress of the rainwater WA to the inside of the front-stage portion FB is prevented by the partition plate 18.

Therefore, electric components such as the blower 20 can be prevented from getting wet by the rainwater WA entered the inside via the exhaust openings 17a and 17b while enabling to discharge heat directed to the heat sink 19 to the outside via the exhaust openings 17a and 17b. Consequently, the waterproof property of electric components such as the blower 20 can be ensured without taking a waterproof measure by using packing or caulking and deterioration of the heat dissipation property can be suppressed. Therefore, even when the power conditioner 3 is installed outside, the service life of the power conditioner 3 can be prolonged.

Moreover, the exhaust openings 17a and 17b are arranged at the position lower than the lines that intersect with the side plates 11a and 11b when being drawn in the direction of the side plates 11a and 11b from the upper end portion of the side surfaces of the heat sink 19 at the angle θ of 45°, so that the upper end portion of the heat sink 19 can be prevented from getting wet by the rainwater WA entered the inside via the exhaust openings 17a and 17b. Therefore, it becomes possible to prevent the rainwater WA entered the inside via the exhaust openings 17a and 17b from entering between the heat dissipation fins 19a via the upper end portion of the heat sink 19 and falling onto the blast surface of the blower 20. Thus, the blower 20 can be prevented from getting wet by the rainwater WA.

In the above described embodiment, the method of arranging the separator 21 between the blower 20 and the side plates 11a and 11b is explained, however, the separator 21 between the blower 20 and the side plates 11a and 11b can be removed. In this case, however, in order to prevent the rainwater WA entered the inside via the exhaust openings 17a and 17b from directly splashing on the blower 20, the exhaust openings 17a and 17b are preferably arranged on the upper side of the lower end portion of the heat sink 19.

### Industrial Applicability

As above, the electronic device accommodating unit according to the present invention can prevent rainwater or the like from entering an electric component in a casing without using packing or caulking even in the case of being installed outside and suppress deterioration of a heat dissipation property in the casing, and therefore is suitable for a waterproof structure of a power conditioner for outdoor installation.

### Reference Signs List

- 1: ROOF

- 2: SOLAR PANEL
- 3: POWER CONDITIONER
- 3a: DCDC CONVERTER
- 3b: INVERTER
- 4: DISTRIBUTION BOARD
- 5: ELECTRICITY METER
- 6: DISTRIBUTION LINE
- 11a, 11b: SIDE PLATE
- 12: BACK PLATE
- 13: TOP PLATE
- 14: BOTTOM PLATE
- 15: FRONT DOOR
- 17a, 17b: EXHAUST OPENING
- 18: PARTITION PLATE
- 19: HEAT SINK
- 19a: HEAT DISSIPATION FIN
- 20: BLOWER
- 21: SEPARATOR
- 22: CAPACITOR
- 23: AC TERMINAL BLOCK
- 24: DC INPUT TERMINAL
- 25: SURGE ABSORBER
- 26: SWITCH
- 27: REACTOR
- 28: BLOWER COVER

## Claims

1. An electronic device accommodating unit comprising:
a casing in which a bottom plate, a back plate, a top plate, a front door, and a pair of side plates are provided;
a blower that blows air into the casing through the bottom plate;
a heat sink in which fins are arranged along a blowing direction of the blower in such a manner as to face the back plate, a side surface is arranged to be spaced apart from the side plate, and an upper end portion is arranged to be spaced apart from the top plate; and
an exhaust opening that is provided in the side plate and communicates with a clearance between the side surface of the heat sink and the side plate.

2. The electronic device accommodating unit according to claim 1, further comprising a separator that separates an air passage from the blower to the heat sink from an air passage along the side plate that communicates with the exhaust opening.

3. The electronic device accommodating unit according to claim 1 or 2, wherein the exhaust opening is arranged at a position lower than a line that intersects with the side plate when being drawn from the upper end portion of the side surface of the heat sink in a direction of the side plate at an angle of 45°.

4. The electronic device accommodating unit according to any one of claims 1 to 3, further comprising:
a partition plate that is arranged on a heat dissipation surface of the heat sink, and partitions the casing in a depth direction to cover the clearance between the side surface of the heat sink and the side plate and a clearance between the upper end portion of the heat sink and the top plate; and
an electronic device that is arranged on a front side of the casing partitioned by the partition plate.
